(19) Europäisches Patentamt
European Patent Office
Office européen des brevets

(11) **EP 1 969 384 B1**

(12) **FASCICULE DE BREVET EUROPEEN**

(45) Date de publication et mention de la délivrance du brevet:
**13.02.2013 Bulletin 2013/07**

(51) Int Cl.:
***G01R 33/3815*** *(2006.01)*

(21) Numéro de dépôt: **06847224.0**

(22) Date de dépôt: **29.12.2006**

(86) Numéro de dépôt international:
**PCT/FR2006/051439**

(87) Numéro de publication internationale:
**WO 2007/077383 (12.07.2007 Gazette 2007/28)**

(54) **BOBINE SUPRACONDUCTRICE SOUS LA FORME DE DOUBLE GALETTES POUR LA CREATION D'UN CHAMP MAGNETIQUE HOMOGENE DANS UNE ZONE D'INTERET, NOTAMMENT POUR L'IMAGERIE PAR RMN**

VERFAHREN UND EINRICHTUNG ZUM ERZEUGEN EINES HOMOGENEN MAGNETFELDS IN EINEM INTERESSIERENDEN BEREICH, INSBESONDERE FÜR NMR-BILDGEBUNG

METHOD AND DEVICE FOR GENERATING A HOMOGENEOUS MAGNETIC FIELD IN AN AREA OF INTEREST, ESPECIALLY FOR NMR IMAGING

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **30.12.2005 FR 0554152**

(43) Date de publication de la demande:
**17.09.2008 Bulletin 2008/38**

(73) Titulaire: **Commissariat à l'Énergie Atomique et aux Énergies Alternatives**
**75015 Paris (FR)**

(72) Inventeur: **AUBERT, Guy**
**F-86000 Poitiers (FR)**

(74) Mandataire: **Thévenet, Jean-Bruno et al**
**Cabinet Beau de Loménie**
**158, rue de l'Université**
**75340 Paris Cédex 07 (FR)**

(56) Documents cités:
**EP-A- 0 468 415     EP-A- 0 472 197**
**EP-A- 0 724 273     EP-A- 0 807 939**
**WO-A-01/06524       US-A- 4 623 864**
**US-A- 5 581 220**

• **H.LEE ET AL.: "A High-Temperature Superconducting Double-Pancake Insert for an NMR Magnet" IEEE TRANSACTIONS ON APPLIED SUPERCONDUCTIVITY, vol. 13, no. 2, 2003, pages 1546-1549, XP002380205**
• **PATENT ABSTRACTS OF JAPAN vol. 013, no. 433 (E-824), 27 septembre 1989 (1989-09-27) -& JP 01 160354 A (HITACHI LTD), 23 juin 1989 (1989-06-23)**
• **PATENT ABSTRACTS OF JAPAN vol. 1999, no. 10, 31 août 1999 (1999-08-31) -& JP 11 135319 A (MITSUBISHI HEAVY IND LTD), 21 mai 1999 (1999-05-21)**

EP 1 969 384 B1

**Description**

La présente invention a pour objet un procédé et un dispositif de création d'un champ magnétique homogène dans une région prédéterminée de l'espace constituant une zone d'intérêt. L'invention trouve son domaine d'application pour la résonance magnétique nucléaire (RMN) et l'imagerie par résonance magnétique (IRM).

On rappelle qu'une installation d'imagerie par RMN comprend entre autres :

- un aimant susceptible de créer un champ magnétique (champ de base) intense et uniforme dans un volume d'examen suffisamment grand pour accueillir un patient,
- un ensemble de bobines de gradients agencé généralement sur un même mandrin cylindrique pour pouvoir engendrer des gradients de champ magnétique suivant des directions prédéterminées dans le volume d'examen, au cours de séquences successives,
- un dispositif d'émission réception radiofréquence pour exciter les spins des noyaux d'atomes pour lesquels les conditions de RMN se trouvent réunies.

Pour créer le champ de base, il est ainsi nécessaire de pouvoir disposer d'aimants dont le champ magnétique interne possède une grande homogénéité spatiale.

Les fréquences (et les intensités de champ qui leurs sont proportionnelles) utilisées en RMN et en IRM sont de plus en plus grandes. On approche en effet le gigahertz pour la RMN du proton, soit près de 23,5 T, dans de petits volumes et l'on envisage d'atteindre 500 MHz en IRM du proton, soit près de 11,75 T, dans des diamètres utiles de l'ordre du mètre. Les aimants correspondants sont donc exclusivement supraconducteurs. En effet ces valeurs de champ conduiraient à des puissances dissipées prohibitives pour des aimants résistifs et elles sont inaccessibles aux aimants permanents car l'aimantation des matériaux existants n'est pas suffisante.

L'augmentation de intensité du champ magnétique dans le volume intérieur d'intérêt entraîne une augmentation du champ dans l'espace extérieur à l'aimant. Les règles de sécurité en vigueur considèrent notamment que des précautions particulières doivent être prises dans les zones où le champ dépasse la « limite des 5 gauss », soit 0,5 mT seulement. Sans contre-mesures spécifiques, cette limite peut se situer à plusieurs dizaines de mètres du centre d'un aimant d'IRM à haut champ, ce qui est en général inacceptable.

Une première possibilité pour rapprocher cette limite de l'aimant consiste à l'enfermer dans une « boîte » en fer doux aux parois suffisamment épaisses pour que le champ à l'extérieur de celle-ci soit inférieur à une valeur donnée, par exemple 0,5 mT. On réalise ainsi un « blindage passif » dont le principal inconvénient est qu'il peut nécessiter des centaines de tonnes de fer pour un aimant d'IRM à haut champ, ce qui peut également devenir inacceptable.

Une solution beaucoup plus élégante consiste à disposer, autour de l'aimant principal, un second aimant, de plus grand diamètre, produisant un champ de sens contraire. Si l'on diminue ainsi le champ utile dans le volume d'intérêt, on diminue dans des proportions beaucoup plus importantes le champ dans l'espace extérieur et l'on peut ramener la limite des 5 gauss à la distance souhaitée du centre de l'aimant. En référence à la solution précédente et par abus de langage, on dit que l'on réalise ainsi un « blindage actif » de l'aimant.

On indiquera ci-dessous les principes de l'optimisation d'aimants supraconducteurs.

On cherche en général à réaliser, au moindre coût, un aimant produisant un champ magnétique intérieur de caractéristiques données (intensité, homogénéité spatiale dans un volume d'intérêt), avec une accessibilité également fixée (espace libre autour du volume d'intérêt) et des conditions supplémentaires éventuelles sur le champ extérieur si l'on veut réaliser un blindage actif.

Si l'on s'intéresse plus particulièrement aux aimants d'IRM pour l'homme, la géométrie la plus appropriée consiste à prévoir un accès libre en forme de tunnel cylindrique dans lequel on introduira longitudinalement le sujet.

On considèrera donc pour la suite que l'aimant a une symétrie axiale autour de l'axe $Oz$ avec une ouverture circulaire libre de diamètre $D$ (il s'agit ici du diamètre au-delà duquel doivent se situer les conducteurs des aimants supraconducteurs. L'ouverture libre réelle est légèrement inférieure à cause des enveloppes cryogéniques qui sont nécessaires).

Outre les coordonnées cartésiennes ($x,y,z$), on utilisera le cas échéant les coordonnées cylindriques ($\rho,\varphi,z$) et sphériques ($r,\vartheta,\varphi$) associées.

Le problème consiste donc à déterminer la densité de courant « hors tout » ou « technique » $j = j_\varphi(\rho,z)u_\varphi$ du bobinage ainsi que la forme $\Sigma$ de sa demi-section axiale, extérieure à celle du cylindre libre de diamètre $D$, pour remplir les conditions fixées pour le champ magnétique avec une capacité de transport de courant. $\iiint|\vec{j}|d\tau$ minimale.

On notera qu'un « conducteur » réel est schématiquement constitué d'un ensemble de filaments supraconducteurs qui transporteront effectivement seuls le courant, entourés d'une certaine quantité de cuivre. Cet ensemble constitue un fil ou câble de section généralement circulaire ou rectangulaire recouvert d'un isolant (émail ou autre). Le bobinage d'un tel conducteur pourra comporter des vides (nécessairement si la section est circulaire) ainsi que des éléments de renfort mécanique en acier amagnétique par exemple. La densité de courant « hors tout » efface ces détails de structure par une moyenne à plus grande échelle du type « approximation du milieu continu ». Si les câbles ont des sections de dimensions importantes, on pourra, pour des calculs plus raffinés, notamment d'homogénéité spatiale du champ, revenir à la position même des brins supraconducteurs et à la densité de courant qu'ils transportent effectivement.

La capacité de transport de courant d'un volume $V$ de bobinage où la densité de courant $j_0$ est uniforme est simplement $j_0 V$ et si le conducteur utilisé a une section constante et transporte un courant d'intensité $I$, elle est égale à $Il$ où $l$ est la longueur de conducteur correspondante. Les performances économiques des conducteurs sont comparées au moyen de leur coût pour une capacité donnée, par exemple □ $10/(kA.m)$ pour le cuivre à la température ambiante, □ $1/(kA.m)$ pour le NbTi à 5 T et 4,2 K,..

L'analyse dimensionnelle conduit à définir le facteur de qualité $Q \leq 1$ d'un aimant supraconducteur, analogue au facteur de Fabry pour les aimants résistifs, par la relation :

$$B_0 = Q \frac{\mu_0 \iiint |\vec{j}| d\tau}{\pi D^2}$$

où $B_0$ est le champ au centre du volume d'intérêt. La valeur maximum 1 de $Q$ est obtenue pour une spire circulaire dont les dimensions de la section sont très petites par rapport au diamètre. Toute autre condition ou contrainte imposée en plus du respect du diamètre libre $D$ entraînera une diminution de $Q$, donc un coût supplémentaire pour la même valeur de champ.

Un aimant réel est en pratique constitué d'un ensemble de $N$ bobinages coaxiaux de section rectangulaire à densité de courant « hors tout » uniforme, caractérisés chacun par cinq paramètres $(a_1, a_2 > a_1, b_1, b_2 > b_1 j_0)_{i \in [1,N]}$, où a1 et a2 sont respectivement des rayons intérieur et extérieur, $b_1$ et $b_2$ sont les cotes $z$ des extrémités, et $j_0$ est la densité de courant mesurée algébriquement autour de $Oz$.

Les conditions imposées au champ magnétique ainsi que la fonction objectif à minimiser (capacité totale de transport de courant) sont des fonctions non linéaires de ces $5N$ paramètres à déterminer qui peuvent être par ailleurs soumis à des bornes comme $a_{1i} \geq \dfrac{D}{2} \quad \forall i$ pour garantir le diamètre $D$ du tunnel d'accès, $a_{2i} \leq \dfrac{D'}{2} \quad \forall i$ si l'on veut limiter à $D'$ le diamètre extérieur maximum. ou à des contraintes plus compliquées comme celles limitant $j_{0i}$ en fonction du champ maximum (« peak field ») auquel est soumis le conducteur dans le bobinage $i$.

D'un point de vue mathématique, il s'agit d'un problème d'optimisation non linéaire avec contraintes non linéaires et bornes éventuelles sur certaines variables ou combinaisons linéaires de variables, dont les difficultés et les méthodes de résolution sont bien connues (V. par exemple le chapitre E04 de la librairie mathématique NAG ou le chapitre 10 de « Numerical recipes in Fortran 77 : The Art of Scientific Computing, W. H. Press *et al.,* Cambridge University Press) dès lors que l'on exprime convenablement les conditions imposées au champ.

Parmi ces contraintes, celles relatives à l'homogénéité spatiale du champ sont essentielles pour les aimants de RMN ou d'IRM.

Dans une région de l'espace « magnétiquement » vide (i.e. sans courants électriques ni matériau de susceptibilité magnétique non négligeable), chaque composante $B_x$, $B_y$ et $B_z$ du champ magnétique a son laplacien nul. Par exemple, quelles que soient les sources du champ, $\Delta B_z = 0$ et $B_z(\vec{r})$ a un développement unique en harmoniques sphériques de la forme :

$$B_z(r, \theta, \varphi) = B_0 + \sum_{n=1}^{\infty} r^n \left[ Z_n P_n(\cos\theta) + \sum_{m=1}^{n} \left( X_n^m \cos m\varphi + Y_n^m \sin m\varphi \right) W_n^m P_n^m(\cos\theta) \right]$$

où $W_n^m$ est un facteur numérique de pondération tel que $\left| W_n^m P_n^m(\cos\theta) \right| \leq 1$ comme $|P_n(\cos\theta)|$.

Ce développement n'est valable que pour $r < r_{max}$, rayon de la plus grande sphère « magnétiquement » vide de centre O. Les coefficients de degré $n$ (on appelle m l'ordre) sont de la forme $\alpha r_{max}^{-n}$ où $\alpha$ a la dimension d'un champ et le développement converge d'autant plus rapidement que $r$ est inférieur à $r_{max}$.

L'ensemble de coefficients $B_0$, $Z_n$, $X_n^m, Y_n^m$ est unique et permet d'exprimer non seulement $B_z$ mais aussi les autres composantes du champ ainsi que les potentiels scalaire et vecteur dont il dérive.

Comme on cherche à réaliser le champ le plus homogène possible $\vec{B} = B_0\vec{u}_z$ dans le volume d'intérêt autour de l'origine $O$, on ne s'intéressera qu'à la composante $B_z$. En effet, si cette homogénéité n'est réalisée que de façon approchée, soit $\vec{B} = B_0\vec{u}_z + \vec{b}$, avec $|\vec{b}|\square B_0$, la fréquence de résonance est proportionnelle à :

$$\left|\vec{B}\right| = \sqrt{\left(B_0 + b_z\right)^2 + b_x^2 + b_y^2} = B_0\sqrt{1 + 2\frac{b_z}{B_0} + \frac{b^2}{B_0^2}}$$

$$\square\ B_0 + b_z + \frac{b_x^2 + b_y^2}{2B_0} + \ldots = B_0 + b_z + B_0 \times O\left(\frac{b}{B_0}\right)^2$$

On voit donc que seule la composante $b_z$ intervient par exemple au niveau du ppm tant que $\dfrac{b}{B_0} \leq \square\ 10^{-3}$.

Les fonctions $r^n P_n^m\left(\cos\vartheta\right)$ $\forall\ n \geq 0, 0 \leq m \leq n$ constituent un ensemble complet de fonctions orthogonales ce qui implique que les écarts à l'homogénéité représentés par l'une de ses fonctions ne peuvent pas être compensés par des écarts représentés par une autre de ces fonctions sauf en un point particulier, mais certainement pas dans tout le volume d'intérêt. Comme les coefficients $Z_n, X_n^m, Y_n^m$ gouvernant ces écarts sont des fonctions décroissantes du degré $n$, on obtiendra une homogénéité spatiale d'autant meilleure que l'on réalisera une géométrie des sources de champ (bobinages) telle que tous ces coefficients soient nuls pour tous les degrés inférieurs ou égaux à un degré donné $n_0$.

On utilisera prioritairement le principe de symétrie pour garantir la nullité de certains de ces coefficients. Ainsi, si le système de sources possède, comme dans la situation considérée, une symétrie axiale ou de révolution autour de l'axe $Oz$, tous les coefficients $X_n^m, Y_n^m$ sont identiquement nuls. Si de plus il est symétrique par rapport au plan $xOy$, tous les coefficients de degré impair $Z_{2p+1}$ sont aussi identiquement nuls et le développement de $B_z$ se réduit à :

$$B_z(r,\theta,\varphi) = B_0 + \sum_{p=1}^{\infty} Z_{2p} r^{2p} P_{2p}(\cos\theta)$$

Le champ a alors par ailleurs une composante perpendiculaire à l'axe :

$$B_\rho(r,\theta,\varphi) = -\sum_{p=1}^{\infty} \frac{1}{2p+1} Z_{2p} r^{2p} P_{2p}^1(\cos\theta)$$

Pour obtenir l'homogénéité souhaitée, il faudra donc déterminer les 5N paramètres $(a_1, a_2 > a_1, b_1, b_2 > b_1, j_0)_{i \in [1,N]}$ des bobinages de telle façon que $Z_{2p} \equiv 0\ \forall p \leq p_0$, les écarts à l'homogénéité étant alors gouvernés par le premier coefficient non nul $Z_{2(p0+1)}$.

Si l'on considère deux spires circulaires coaxiales de section très petite devant leur rayon, parcourues par des courants de même intensité et séparées par une distance égale à leur rayon, spires dites en position de Helmoltz, $Z_2 \equiv 0$, l'homogénéité du champ au voisinage du centre $O$ du système étant gouvernée par $Z_4$. Cette situation correspond à $p_0$ = 1 dans la discussion générale précédente. Dans la pratique, pour les aimants de RMN ou dIRM considérés où l'on cherche à minimiser la quantité de supraconducteur utilisée, c'est-à-dire à avoir le « diamètre » du volume d'intérêt aussi proche que possible du diamètre $D$ du tunnel libre de l'aimant, on pourra aller jusqu'à $p_0$ = 6 ou 7.

Une fois déterminée la géométrie théorique suivant les modalités définies précédemment, il faut réaliser pratiquement, avec les conducteurs réels, des bobinages à demi-section axiale rectangulaire qui reproduisent aussi fidèlement que possible la géométrie souhaitée. Les différences avec celle-ci, introduites lors de cette réalisation pratique, ne modifieront pas sensiblement les coefficients non nuls du développement théorique mais feront par contre apparaître des coefficients d'ordre inférieur qui auraient dû être nuls. Par exemple, une légère dissymétrie des bobinages par rapport au plan $xOy$, fera apparaître des coefficients impairs $Z_1, Z_3, ...$ d'autant plus importants que la dissymétrie est importante. Une ovalisation des mandrins de bobinage conduira à l'apparition de coefficients du type $X_n^m, Y_n^m$. Ces inhomogénéités devront être corrigées ultérieurement par des dispositifs appropriés appelés « shims ».

Si les contraintes imposées lors de l'optimisation décrite précédemment le permettent, les $j_{0i}$ des bobinages seront différents. En particulier, les densités de courant « hors tout » seront plus grandes dans les régions où le champ magnétique est moins élevé. Comme la stabilité temporelle de l'aimant impose pratiquement que tous ces bobinages soient connectés en série, donc avec la même intensité parcourant chacun des conducteurs, on aura des conducteurs réels différents pour chaque valeur de la densité de courant. On dit alors que l'on fait de l'échelonnement (« grading »).

La technique employée pour les aimants de RMN ou d'IRM est celle du bobinage en couches. W. L. L. Lenders a notamment proposé (Philips Tech. Rev., 23, pp 365-404, 1962), pour des conducteurs de section circulaire, le bobinage dit orthocyclique qui assure le meilleur « remplissage » possible de la demi-section axiale rectangulaire.

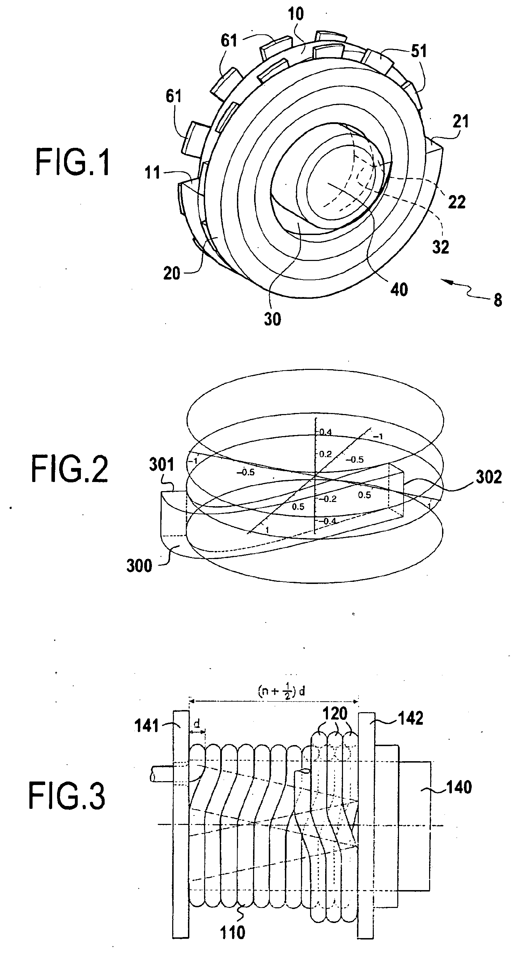

Cette technique est illustrée sur la Figure 3 où l'on voit un mandrin 140 avec deux flasques 141, 142 entre lesquels sont formés des première et deuxième couches 110, 120 à partir d'un fil à section circulaire de diamètre d. Un nombre n de spires est formé entre les flasques 141, 142 avec un décalage d'une valeur d/2 entre les spires de deux couches successives 110, 120, la distance entre les flasques 141, 142 étant égale à (n+1/2)d.

On peut également bobiner les couches en hélices avec la difficulté incontournable du passage d'une couche à la suivante à chacune des extrémités au moyen de cales isolantes judicieusement disposées.

On notera que les longueurs disponibles de conducteur sont limitées par les techniques de fabrication utilisées et il faut donc assumer l'existence de jonctions entre longueurs successives. La réalisation de ces jonctions, dont on souhaite qu'elles soient aussi peu résistantes que possible, sinon supraconductrices, pose des problèmes particuliers. Afin de ne pas perturber l'homogénéité spatiale ainsi que pour les placer dans des zones de champ faible, ces jonctions doivent être éloignées du volume d'intérêt.

Les aimants d'IRM à haut champ (≥ 10 T) nécessitent des masses de conducteur considérables (plusieurs dizaines de tonnes) et la technique du bobinage en couche conduit à des bobinages individuels $i \in [1, N]$ de masse très importante, donc difficilement manipulables, avec de nombreuses jonctions pas toujours faciles à disposer. L'énergie magnétique stockée dans l'aimant devient également très importante (quelque 100 $MJ$) ce qui impose d'utiliser des intensités de courant aussi élevées que possible ( > 1000 A) afin de réduire la tension qui apparaîtrait en cas de transition accidentelle de l'état supraconducteur vers l'état normal de l'aimant (phénomène de « quench »).

La section du conducteur à utiliser peut alors être égale ou supérieure à environ 10mm$^2$, ce qui rend difficile la réalisation de bobinages selon les techniques connues jusqu'à présent pour réaliser des aimants pour l'IRM.

On connaît encore par le document EP-A-0724273 un dispositif de création d'un champ magnétique homogène dans une zone d'intérêt comprenant un agencement de bobines supraconductrices. Ce document a servi de base pour la forme en deux parties des revendications indépendantes annexées.

Par ailleurs, le document US-A-5581220 divulgue un procédé de fabrication d'une bobine à doubles galettes.

L'invention vise précisément à remédier aux inconvénients précités et à permettre la réalisation d'aimants à haut champ capables de créer un champ magnétique intérieur homogène tout en facilitant la manipulation et l'assemblage des éléments constitutifs lors de la fabrication.

L'invention vise ainsi à réaliser des dispositifs de création de champ magnétique homogène dont le coût de fabrication soit réduit et les performances soient améliorées, tout en autorisant une grande souplesse de mise en oeuvre.

L'invention vise encore à permettre la réalisation d'aimants supraconducteurs à champ magnétique extérieur réduit.

Un dispositif de création de champ magnétique selon l'invention et un procédé de fabrication d'un dispositif de création d'un champ magnétique selon l'invention sont définis dans les revendications annexées.

Ces buts sont atteints, conformément à l'invention, grâce à un dispositif de création d'un champ magnétique homogène dans une zone d'intérêt, pour la résonance magnétique nucléaire et l'imagerie par résonance magnétique, comprenant un agencement de bobines supraconductrices disposées autour d'un axe longitudinal (z) de ladite zone d'intérêt, laquelle zone d'intérêt se trouve à l'intérieur dudit agencement de bobines supraconductrices, l'agencement de bobines supraconductrices comprenant un ensemble de un ou plusieurs blocs, chaque bloc étant formé d'un ensemble d'éléments modulaires répartis le long dudit axe longitudinal et centrés sur cet axe longitudinal, chaque élément modulaire comprenant un conducteur de section rectangulaire en matériau supraconducteur enroulé de façon continue sous la forme d'une double galette avec une première galette simple plane, une deuxième galette simple plane juxtaposée à la première galette simple parallèlement à celle-ci et un tronçon de transition sans jonction interne entre les première et deuxième galettes simples, chaque galette simple comprenant une extrémité de raccordement située à la partie périphérique externe de la galette pour un raccordement par une jonction à une extrémité de raccordement d'un élément modulaire voisin et le tronçon de transition permettant, suivant l'axe longitudinal, un décalage de la deuxième galette simple par rapport à la première galette simple, au moins égal à la dimension transversale du conducteur selon cet axe, chacune des première et deuxième galettes simples planes étant réalisée à partir de demi-circonférences de rayon croissant de la moitié de l'épaisseur du conducteur entre deux demi-circonférences consécutives, avec une alternance entre deux centres pour les demi-circonférences, séparés de la moitié de l'épaisseur du conducteur.

Selon un mode particulier de réalisation, des premières cales isolantes sont disposées entre la première galette simple et la deuxième galette simple au sein de chaque élément modulaire et des deuxièmes cales isolantes sont disposées entre les éléments modulaires successifs.

Le tronçon de transition s'étend avantageusement autour de l'axe longitudinal sur un intervalle inférieur à $2\pi$ et de préférence sur un intervalle inférieur à $\pi$.

Selon un mode particulier de réalisation le tronçon de transition est réalisé sous la forme d'une couronne sinusoïdale constituée par l'enroulement d'une sinusoïde autour d'un cylindre de révolution ayant pour axe ledit axe longitudinal.

Chaque bloc comprend plusieurs dizaines d'éléments modulaires identiques.

Selon un mode de réalisation préférentiel, le dispositif comprend au moins sept blocs d'éléments modulaires identiques, disposés coaxialement selon ledit axe longitudinal symétriquement par rapport à un plan médian de la zone d'intérêt perpendiculaire audit axe longitudinal, l'épaisseur des blocs et la longueur de l'espace libre de séparation entre deux blocs adjacents augmentant du plan médian vers les extrémités du dispositif.

Avantageusement, le dispositif comprend en outre au moins une bobine supraconductrice de compensation qui entoure les blocs d'éléments modulaires et présente un axe coïncidant avec l'axe longitudinal, ladite bobine supraconductrice de compensation étant adaptée pour être parcourue par un courant de sens inverse à ceux desdits blocs.

Dans ce cas, la bobine supraconductrice de compensation est réalisée sous la forme d'un bobinage en couches.

Selon un exemple de réalisation particulier, l'ensemble des blocs et bobines de compensation parcourus par des courants sont tels qu'au moins le moment dipolaire $Z'_2$ de la distribution de courant correspondant au champ magnétique à l'extérieur de la zone d'intérêt est nul, en même temps que les coefficients $Z_{2p}$ du développement du champ magnétique dans la zone d'intérêt sont nuls jusqu'à un ordre supérieur à 2 fixé $Z_{2p0}$.

Selon un autre exemple de réalisation particulier, l'ensemble des blocs et bobines de compensation parcourus par des courants sont tels qu'au moins le moment dipolaire $Z'_2$ et le moment quadrupolaire $Z'_4$ de la distribution de courant correspondant au champ magnétique à l'extérieur de la zone d'intérêt sont nuls, en même temps que les coefficients $Z_{2p}$ du développement du champ magnétique dans la zone d'intérêt sont nuls jusqu'à un ordre supérieur à 2 fixé $Z_{2p0}$.

D'une manière générale, l'ensemble des blocs et des bobines de compensation parcourus par des courants sont tels que les moments magnétiques multipolaires de la distribution de courant correspondant au champ magnétique à l'extérieur de la zone d'intérêt sont nuls depuis l'ordre inférieur 2 ($Z'_2$) jusqu'à un ordre supérieur à 2 fixé $Z'_{2p0}$ en même temps que les coefficients $Z_{2p}$ du développement du champ magnétique dans la zone d'intérêt sont nuls jusqu'à un ordre supérieur à 2 fixé $Z_{2p0}$.

A titre d'exemple, les blocs d'éléments modulaires sont disposés autour d'une zone d'intérêt dont le diamètre est égal ou supérieur à 1 mètre.

Selon une application possible, le champ magnétique créé par les blocs d'éléments modulaires est supérieur ou égal à 10 T.

La section du conducteur d'un élément modulaire est comprise entre quelques millimètres carrés et quelques dizaines de millimètres carrés.

Selon un exemple de réalisation, un élément modulaire présente une masse comprise entre quelques dizaines de kilogrammes et une centaine de kilogrammes.

L'invention concerne également un procédé de fabrication d'un dispositif de création d'un champ magnétique homogène dans une zone d'intérêt pour la résonance magnétique nucléaire et l'imagerie par résonance magnétique, caractérisé en ce qu'il comprend les étapes suivantes :

a) préparer une longueur de fil de matériau supraconducteur à section rectangulaire sans raccord,

b) mettre en forme un tronçon central de la longueur de fil pour créer un tronçon de transition entre deux galettes simples juxtaposées,

c) disposer sur un mandrin de forme spécifique et rendre provisoirement solidaire de celui-ci le tronçon de transition formé et la moitié de la longueur de fil s'étendant d'un côté du tronçon de transition,

d) former par rotation du mandrin dans un premier sens une première galette simple plane à partir de l'autre moitié de la longueur de fil restée libre par rapport au mandrin, le mandrin présentant une forme telle que la première galette simple plane est formée de demi-circonférences de rayon croissant de la moitié de l'épaisseur du conducteur entre deux demi-circonférences consécutives, avec une alternance entre deux centres pour les demi-circonférences, séparés de la moitié de l'épaisseur du conducteur,

e) rendre provisoirement solidaire du mandrin la première galette simple formée et libérer le tronçon de transition de la moitié de la longueur de fil précédemment rendue provisoirement solidaire du mandrin,

f) former par rotation du mandrin dans un deuxième sens une deuxième galette simple plane à partir de la moitié de la longueur du fil libérée, le mandrin représentant une forme telle que la deuxième galette simple plane est formée de demi-circonférences de rayon croissant de la moitié de l'épaisseur du conducteur entre deux demi-circonférences consécutives, avec une alternance entre deux centres pour les demi-circonférences, séparés de la moitié de l'épaisseur du conducteur,

g) retirer du mandrin l'élément modulaire obtenu et former des extrémités de raccordement à la partie périphérique externe de chaque galette simple, et

h) assembler et raccorder le long d'un axe longitudinal une pluralité d'éléments modulaires préparés selon les étapes a) à g).

Le procédé peut en outre comprendre l'étape d'insérer de premières cales isolantes entre la première galette simple et la deuxième galette simple au sein de chaque élément modulaire et d'insérer de deuxièmes cales isolantes entre les différents éléments modulaires successifs d'un même bloc.

D'autres caractéristiques et avantages de l'invention ressortiront de la description détaillée de modes particuliers de réalisation, donnés à titre d'exemples, en référence aux dessins annexés, sur lesquels :

- la Figure 1 est une vue en perspective d'un exemple d'élément modulaire en double galette utilisable dans un dispositif de création de champ magnétique selon l'invention,
- la Figure 2 montre un exemple de tronçon de transition du type couronne sinusoïdale pouvant être mis en oeuvre dans l'élément modulaire de la Figure 1,
- la Figure 3 est une vue en élévation d'un exemple de bobinage en couche,
- la Figure 4 est une vue en perspective d'une première galette simple pouvant être incorporée dans l'élément modulaire de la Figure 1,
- la Figure 5 est une vue en perspective de la galette simple de la Figure 4 à laquelle est rajouté un tronçon de transition,
- la Figure 6 est une vue en perspective d'une galette double selon l'invention,
- la Figure 7 est une vue en plan d'une galette simple telle que celle de la Figure 4,
- la Figure 8 est une vue en perspective montrant le processus d'association de demi-spires circulaires et d'un tronçon de transition pour la constitution d'un élément modulaire à double galette,
- la Figure 9 est une vue en perspective d'un exemple de cale de guidage centrale utilisable dans le processus de fabrication d'un élément modulaire à double galette selon l'invention,
- la Figure 10 est une vue schématique en coupe axiale d'un premier exemple de dispositif de création de champ magnétique selon l'invention avec le tracé des lignes du champ produit,
- la Figure 11 est une vue schématique montrant les contours isomodule du champ magnétique extérieur résiduel créé par le dispositif de la Figure 10,
- la Figure 12 est une vue schématique en coupe axiale d'un deuxième exemple de dispositif de création de champ magnétique selon l'invention, avec le tracé des lignes de champ produit,
- la Figure 13 est une vue schématique montrant les contours isomodule du champ magnétique extérieur résiduel créé par le dispositif de la Figure 12, et
- la Figure 14 est une vue montrant la géométrie de la fibre neutre d'une demi double galette selon l'invention,
- la Figure 14A est une vue selon la flèche XIVA de la figure 14, et
- la Figure 15 est une vue schématique en demi-coupe axiale selon la ligne XV-XV de la Figure 14 montrant les divers enroulements d'une double galette selon l'invention.

Pour créer un champ magnétique homogène relativement intense, tel que le champ de base devant être créé dans une zone d'intérêt d'une installation d'IRM, conformément à l'invention, il est proposé de renoncer aux systèmes de bobinages de l'art antérieur, qui sont généralement des constructions en couches avec moins d'une dizaine de bobines de masse unitaire très importante, de l'ordre de plusieurs centaines de kilogrammes, et de leur substituer des empilements comportant chacun un ensemble d'éléments modulaires 8 de masse relativement modeste, par exemple de l'ordre de 100 kg, et donc faciles à manipuler.

Comme on l'a représenté sur la Figure 1, chaque élément modulaire 8 comprend une double galette réalisée à partir d'un fil en matériau supraconducteur présentant une section rectangulaire assez grande, dont la largeur et la longueur sont typiquement de quelques millimètres.

L'élément modulaire 8 en forme de double galette est sans jonction interne et présente deux extrémités 11, 21 situées à l'extérieur, dans une zone propice à la réalisation de jonctions avec les éléments modulaires adjacents, car le champ magnétique y est beaucoup plus faible qu'au centre de l'aimant.

Les éléments modulaires 8 sont empilés sur le tube central 40 de l'aimant qui présente un axe longitudinal z.

Des cales isolantes 61 sont disposées entre deux éléments modulaires 8 adjacents.

La Figure 1 montre à la fois en arrière-plan les cales isolantes 61 contre lesquelles viendra s'appuyer l'élément modulaire suivant, et des cales isolantes 51 interposées entre les deux galettes simples 10, 20 qui constituent la double galette de l'élément modulaire 8 représenté.

Les cales isolantes 51, 61 permettent une circulation éventuelle de fluide cryogénique, notamment de l'hélium superfluide si l'on veut travailler à une température plus basse que 4,2 K (température d'ébullition de l'hélium dans les conditions normales), afin d'améliorer les propriétés physiques (champ et courant critiques) du supraconducteur utilisé et profiter par ailleurs des propriétés remarquables du superfluide pour mieux stabiliser le fonctionnement de l'aimant.

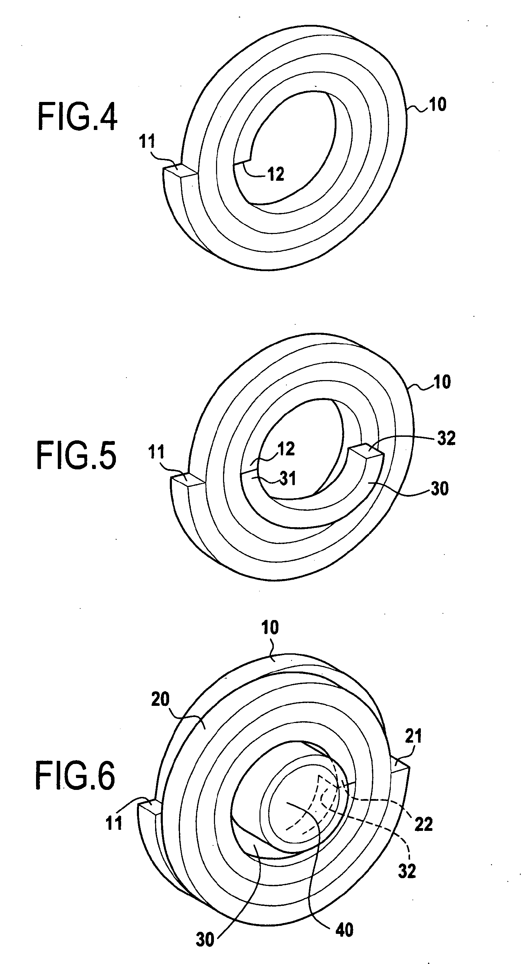

Les Figures 4 à 6 montrent le principe de la constitution d'un bobinage en double galette.

Un exemple de premier bobinage en galette simple 10 est représenté sur la Figure 4. Le conducteur présente une extrémité externe 11 et une extrémité interne 12.

La galette simple 10 pourrait être du type spirale d'Archimède mais est réalisée à partir d'arcs de cercle comme cela sera décrit de façon plus détaillée plus loin.

Pour pouvoir former une double galette, il faut d'abord rajouter à la galette simple 10, à partir de l'extrémité interne 12, un tronçon de transition 30 présentant une première extrémité 31 se raccordant à l'extrémité interne 12 et une seconde extrémité 32 qui se projette hors du plan de la galette simple 10.

Le tronçon de transition 30 permet ainsi de décaler, suivant l'axe de la galette 10, l'extrémité inférieure 12 de la galette simple 10 jusqu'à l'extrémité 32 du tronçon de transition 30, d'une valeur au moins égale à la largeur du conducteur constituant la galette 10. Sur la Figure 5, la zone de transition 30 occupe un demi-tour, mais elle peut être choisie plus grande ou plus petite.

Pour constituer une double galette complète, on raccorde ensuite à l'extrémité intérieure 32 du tronçon de transition 30, l'extrémité intérieure 22 d'une deuxième galette simple 20, qui est identique à la première galette simple 10, mais est retournée face pour face, comme cela est représenté sur la Figure 6. La deuxième galette simple 20 comporte une extrémité extérieure 21 qui constitue la deuxième extrémité de l'élément modulaire formé par cette double galette.

Dans la pratique, on ne procède cependant pas de la manière décrite ci-dessus en référence aux Figures 4 à 6, car on souhaite précisément éviter des jonctions au niveau de raccordement des extrémités 31, 32 du tronçon de transition 30 et la double galette est réalisée à partir d'une longueur de fil d'un seul tenant.

Pour fabriquer une double galette présentant la structure finale de la Figure 6 ou de la Figure 1, on utilise ainsi une longueur unique de fil supraconducteur de section rectangulaire, en commençant le bobinage par le milieu de cette longueur et la mise en forme du tronçon de transition entre les deux galettes simples. On bobine ensuite l'une des deux galettes simples en tournant dans un sens un mandrin, la demi-longueur de fil correspondant à l'autre galette simple étant réservée sur le mandrin et tournant avec celui-ci. On bobine ensuite la seconde galette simple avec la demi-longueur ayant tourné avec le mandrin, en tournant en sens inverse.

L'homogénéité souhaitée pour un aimant utilisée en IRM peut être typiquement de l'ordre de 0,1 ppm dans le volume d'intérêt. Le champ produit en tout point de l'espace par les éléments d'une double galette (zone intérieure de transition et parties spiralées) doit donc être calculé à une précision au moins égale à $10^{-9}B_0$. Il est possible de choisir pour la zone centrale de transition 30 de même que pour les parties planes spiralées 10, 20 des géométries qui facilitent le calcul du champ produit tout en autorisant une réalisation pratique avec une très grande précision mécanique.

La zone centrale de transition 30 peut être très proche du volume d'intérêt pour les doubles galettes les plus centrales et doit donc être déterminée avec soin.

L'origine de la coordonnée cylindrique angulaire φ, étant prise au centre de la zone de transition, cette zone de transition s'étend sur un intervalle $[-\varphi_0, \varphi_0]$ où $\varphi_0 \le \pi$ est un angle à choisir. Si $\varphi_0$ est petit, la transition sera assez brutale et le conducteur assez fortement « tordu », mais les cales mécaniques devant guider le conducteur seront assez faciles à fabriquer. Si l'on augmente $\varphi_0$, la transition sera plus « douce » pour le conducteur mais les cales de guidage seront plus difficiles à réaliser. Un bon compromis consiste à réaliser la transition sur un demi-tour, soit $\varphi_0 = \dfrac{\pi}{2}$.

La forme la plus simple qui conduit à des expressions intégrables avec la précision souhaitée pour le calcul du champ produit par des sections rectangulaires à densité de courant uniforme consiste à donner au conducteur à plat la forme d'une portion de sinusoïde comprise entre un minimum et un maximum consécutifs et de l'enrouler autour d'un cylindre de section circulaire. Les arêtes de la section du conducteur et les lignes de courant ont ainsi des équations de la forme $x = n \cos t$, $y = n \sin t$, $z = h \sin \dfrac{\pi}{2} \dfrac{\varphi}{\varphi_0}$. Une telle courbe est appelée « couronne sinusoïdale » et constitue un cas particulier de courbe de Lissajous 3D. La Figure 2 montre un tronçon de transition 300 pour $\varphi_0 = \dfrac{\pi}{3}$ réalisé de cette manière et se terminant par des extrémités 301 et 302 de raccordement aux parties spiralées planes.

L'épaisseur du conducteur constituant les galettes simples étant constante, le conducteur pour chacune des galettes simples se raccordant géométriquement à la zone de transition pourrait être une spirale d'Archimède.

Toutefois, selon la présente invention, pour faciliter le calcul précis du champ magnétique produit par les galettes simples, on réalise celles-ci à partir de demi-circonférences de rayon croissant de la moitié de l'épaisseur du conducteur entre deux-circonférences consécutives.

On sait en effet calculer avec une très grande précision le champ produit par des conducteurs de section rectangulaire à densité de courant uniforme en forme d'arcs de cercle. On peut donc privilégier cette forme qui est au demeurant tout aussi facile à réaliser qu'une spirale d'Archimède.

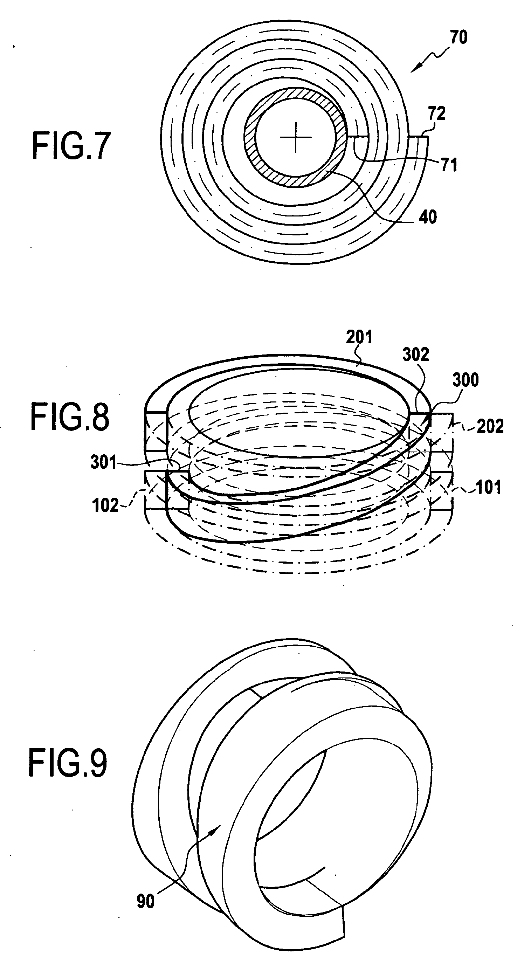

Les Figures 7 et 8 représentent le cas où les galettes en spirales sont telles que l'on raccorde des demi-circonférences de rayons croissant de la moitié de l'épaisseur du conducteur entre deux demi-circonférences consécutives. Le cas représenté correspond à une zone de transition d'un demi-tour ($\varphi_0 = \pi/2$) et il y a alors alternance entre deux centres pour les demi-circonférences, séparés de la moitié de l'épaisseur du conducteur.

La Figure 7 est une vue de face d'une simple galette 70 comportant une extrémité interne 71 devant se raccorder sans jonction à un tronçon de transition et une extrémité extérieure 72 devant être raccordée par une jonction à une autre extrémité externe d'un élément modulaire adjacent.

La Figure 8 est une vue en perspective d'une partie de double galette avec en traits gras le tronçon de transition 300 présentant des extrémités 301, 302, en traits fins continus les premières demi-circonférences 101, 201 raccordées respectivement aux extrémités 301, 302 du tronçon de raccordement 300, et en traits mixtes les demi-circonférences suivantes 102, 202 raccordées respectivement aux demi-circonférences 101, 201.

La Figure 9 montre, pour le même exemple avec une valeur de $\varphi_0$ égale à $\pi/2$, la forme d'une cale 90 de guidage centrale qui garantit la forme du tronçon de transition 300 et du premier demi-tour 101, 201 de chaque galette simple, l'enroulement prenant ensuite naturellement la forme souhaitée.

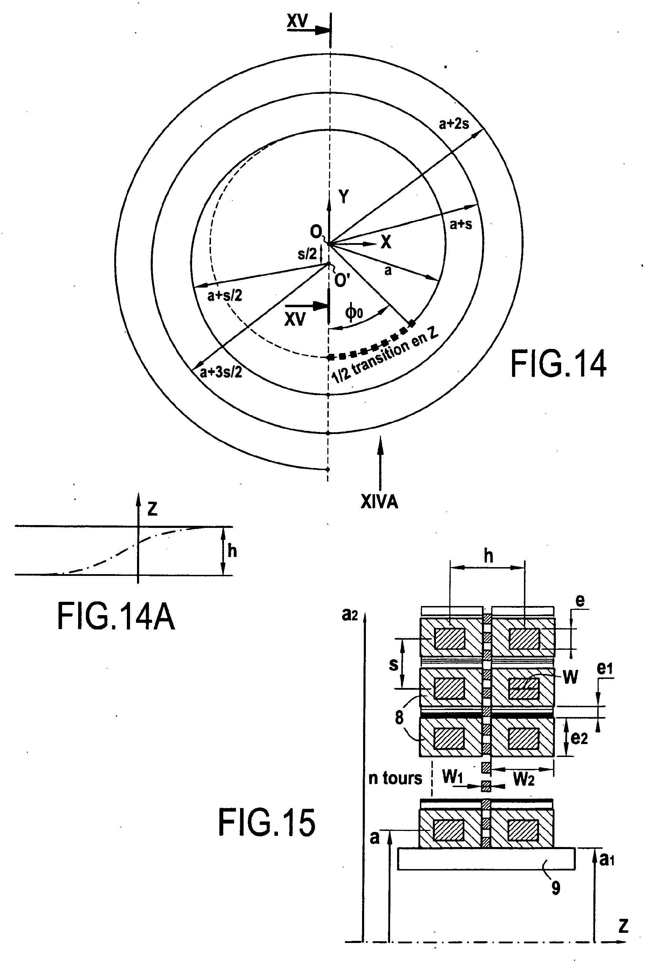

On a mentionné ci-dessus le calcul du champ produit par des sections rectangulaires à densité de courant uniforme pour une zone de transition en forme de couronne sinusoïdale et pour des arcs circulaires. On peut ainsi prendre en considération la structure interne du conducteur utilisé et la distribution effective du courant transporté par les brins supraconducteurs. On peut aller jusqu'à chaque brin assimilé à un fil (il y en a beaucoup mais le calcul est aussi beaucoup plus rapide), ou à un ensemble de brins assimilé à une bande mince comme il en existe dans les câbles du type Rutherford ou à une section à densité uniforme (comme par exemple la section rectangulaire de dimensions w x e de la figure 15) correspondant à l'ensemble des brins d'un conducteur monolithique, ensemble entouré de cuivre qui ne transporte pas de courant.

Les figures 14, 14A et 15 visent à mieux faire comprendre la réalisation d'une double galette selon un mode préférentiel de l'invention, qui est adapté pour permettre la réalisation d'aimants destinés à produire des champs très homogènes.

La figure 14 montre la géométrie de la fibre neutre d'une demi double galette qui est constituée de demi-cercles de rayons croissants et de centres alternés O et O'.

La figure 14A est une vue selon la flèche XIVA de la figure 14 et illustre la zone de transition qui s'étend sur une hauteur totale h selon l'axe z. Si $\varphi_0$ est l'angle sur lequel s'étend la moitié de la zone de transition et si l'origine de la coordonnée cylindrique angulaire $\varphi$ d'un point de la zone de transition est prise au centre de la zone de transition, alors en chaque point de la fibre neutre de la zone de transition, la coordonnée $z(\varphi)$ est donnée par la formule

$$z(\varphi) = \frac{h}{2} \cdot \sin\left( \frac{\pi}{2} \cdot \frac{\varphi}{\varphi_0} \right).$$

La figure 15 montre en coupe selon le plan YOZ de la figure 14 un exemple de demi double galette s'étendant autour d'un mandrin 9.

On voit sur la figure 15 le double enroulement des spires 8 et la distance h entre les fibres neutres de deux galettes simples 8 juxtaposées, cette distance h correspondant à la hauteur de la zone de transition selon l'axe Oz qui constitue l'axe central du mandrin 9 et de la double galette.

Dans le sens radial (axes OX ou OY), les distances correspondent à la distance entre les fibres neutres de deux spires successives.

Si $e_z$ est la largeur d'une spire de section rectangulaire, dans le sens radial et si $e_1$ est l'espace libre entre deux spires contiguës alors on a $s = e_1 + e_2$.

Si par ailleurs la longueur d'une spire de section rectangulaire orientée dans le sens axial de l'axe Oz est désignée par $w_2$ et si $w_1$ est l'espace libre, selon l'axe Oz, entre deux spires adjacentes des deux galettes simples d'une double galette, on a $h = w_1 + w_2$.

Si l'on se reporte à nouveau à la figure 14, avec les notations indiquées ci-dessus, on a pour chacun des enroulements ou spires d'une galette, à partir du début de la demi-transition, les demi-tours suivants :

---

Premier enroulement

Premier ½ tour

          rayon a concentré sur O

Second ½ tour

$$\text{rayon } a + \frac{s}{2} \text{ centré sur O'}$$

---

$i^{\text{ème}}$ enroulement :

Premier ½ tour

rayon $a + (i-1) \cdot s$

          centré sur O

Second ½ tour

$$\text{rayon } a + \frac{2 \cdot i - 1}{2} \cdot s$$

          centré sur O

---

$n^{\text{ème}}$ enroulement :

Premier ½ tour

rayon $a + (n-1) \cdot s$

          centré sur O

---

Second ½ tour

$$\text{rayon } a + \frac{2 \cdot n - 1}{2} \cdot s$$

          centré sur O'

---

Si l'on considère la figure 15, avec les spires de section rectangulaire de dimensions $w_2 \times e_2$ munies d'un isolant d'épaisseur $e_1$ correspondant à l'espace entre deux spires conductrices, on peut avoir les notations suivantes :

Rayon interne hors-tout

$$a_1 = a - \frac{e_2}{2}$$

rayon externe centré O (sans l'isolant)

$$a_{21} = a + (n-1) \cdot s + \frac{e_2}{2}$$
$$= r_i + (n-1) \cdot s + e_2$$

rayon externe centré O' (sans l'isolant)

(suite)

$$a_{22} = a + \frac{2 \cdot n - 1}{2} \cdot s + \frac{e_2}{2}$$

$$= r_i + \frac{2 \cdot n - 1}{2} \cdot s + e_2$$

rayon externe centré O (avec l'isolant)

$$a'_{21} = a + \frac{2 \cdot n - 1}{2} \cdot s + \frac{e_1}{2}$$

$$= r_i + n \cdot s$$

rayon externe centre O' (avec l'isolant)

$$a'_{22} = a + n \cdot s + \frac{e_1}{2}$$

$$= r_i + \frac{2 \cdot n + 1}{2} \cdot s$$

Les éléments modulaires 8 à double galette réalisés de la manière décrite précédemment sont associés dans des empilements ou blocs où les doubles galettes sont réunies entre elles par des jonctions supraconductrices ou aussi peu résistantes électriquement que possible.

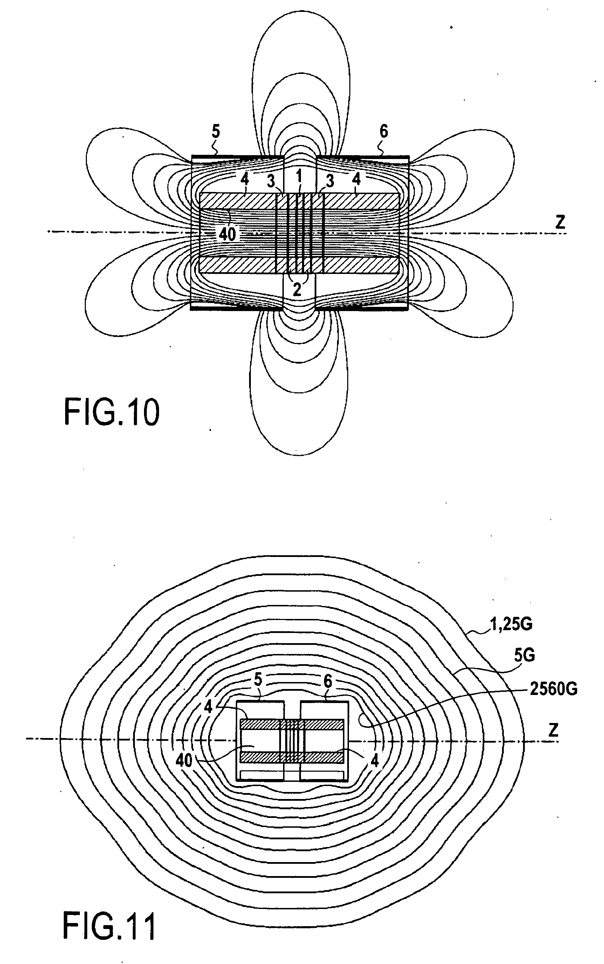

Pour constituer un aimant produisant un champ magnétique homogène, on associe des blocs 1 à 4 coaxiaux selon l'axe z et séparés les uns des autres par des séparations (Figures 10 à 13).

Pour la détermination des différents empilements ou blocs regroupant un ensemble de doubles galettes et donc un nombre double de simples galettes, on peut raisonner d'une façon analogue à ce qui est décrit par exemple dans le brevet US 4 748 429 où les constituants élémentaires sont des disques de Bitter au lieu d'être des galettes simples spiralées.

Pour obtenir un champ magnétique homogène, on doit ainsi disposer un ensemble de galettes simples équivalentes à des disques conducteurs de rayon intérieur $a_1$ et de rayon extérieur $a_2$, d'épaisseur donnée, séparées par des isolants d'épaisseur également donnée et portant une densité de courant uniforme $\vec{j} = j_0 \vec{u}_\varphi$.

Pour obtenir un aimant homogène à l'ordre $2p_0$ (premier coefficient non nul $Z_{2(p0+1)}$), il faut empiler les galettes de la façon la plus serrée possible (c'est-à-dire avec des cales 51 d'épaisseur minimum) dans des blocs eux-mêmes séparés par des espaces libres pour constituer $p_0+1$ blocs 1 à 4 alignés coaxialement.

Les rayons intérieurs $a_1$ des blocs correspondent toujours à la limite $a_1 = D/2$ où D est le diamètre du tunnel d'accès central de la zone d'intérêt si le champ magnétique doit être le plus homogène possible.

Les rayons extérieurs $a_2$ des blocs, les épaisseurs totales des blocs (qui correspondent au nombre de doubles galettes constituant ces blocs) et la longueur des séparations entre les blocs sont déterminés par un calcul d'optimisation selon les règles et principes qui ont été rappelés plus haut pour l'optimisation des aimants supraconducteurs.

D'une façon générale, l'épaisseur des blocs et des séparations augmente du centre vers les extrémités de la zone d'intérêt située à l'intérieur du tunnel central 40.

Il est suffisant de disposer $p_0+1$ blocs pour obtenir l'homogénéité souhaitée à l'ordre $2p_0$. Rien n'interdit naturellement de prévoir un nombre de blocs supérieur, mais ceci impliquera l'utilisation d'une masse plus grande de conducteur, ce qui accroît le coût.

Les rayons extérieurs $a_2$ peuvent être prévus de manière à être légèrement croissant du centre de l'aimant vers les extrémités. Toutefois, il est aussi possible d'imposer que les rayons extérieurs $a_2$ des doubles galettes soient tous identiques de manière à accroître le caractère modulaire et rationaliser la fabrication.

Dans les exemples des Figures 10, 11 et 12, 13, on a un aimant principal composé de sept blocs, à savoir un bloc central 1 de faible épaisseur, deux blocs 2 symétriques de part et d'autre du bloc central et présentant une épaisseur très légèrement supérieure à celle du bloc central 1, une autre paire de blocs 3 symétriques de part et d'autre de la paire de blocs 2, l'épaisseur des blocs 3 étant elle-même supérieure à l'épaisseur des blocs 2, et enfin une paire de blocs 4 symétriques de part et d'autre de la paire de blocs 3, l'épaisseur des blocs 4 étant elle-même largement supérieure à celle des blocs 3. Les séparations entre les blocs 2 et 3 s'étendent sur une longueur légèrement supérieure à celle des séparations entre les blocs 1 et 2. Les séparations entre les blocs 3 et 4 s'étendent elles-mêmes sur une longueur supérieure à celle des séparations entre les blocs 2 et 3.

Les modes de réalisation des Figures 10 à 13 comportent ainsi au total sept blocs ou empilements d'éléments modulaires 8 composés de doubles galettes.

Ces modes de réalisation montrent également la mise en oeuvre de bobinages extérieurs de compensation 5, 6, 7 assurant un blindage actif, c'est-à-dire réduisant par leur présence le champ magnétique rayonné vers l'extérieur par l'ensemble des bobinages de l'aimant.

Dans le mode de réalisation des Figures 10 et 11, les bobinages de compensation sont répartis en deux ensembles 5, 6 constitués par des bobinages en couches.

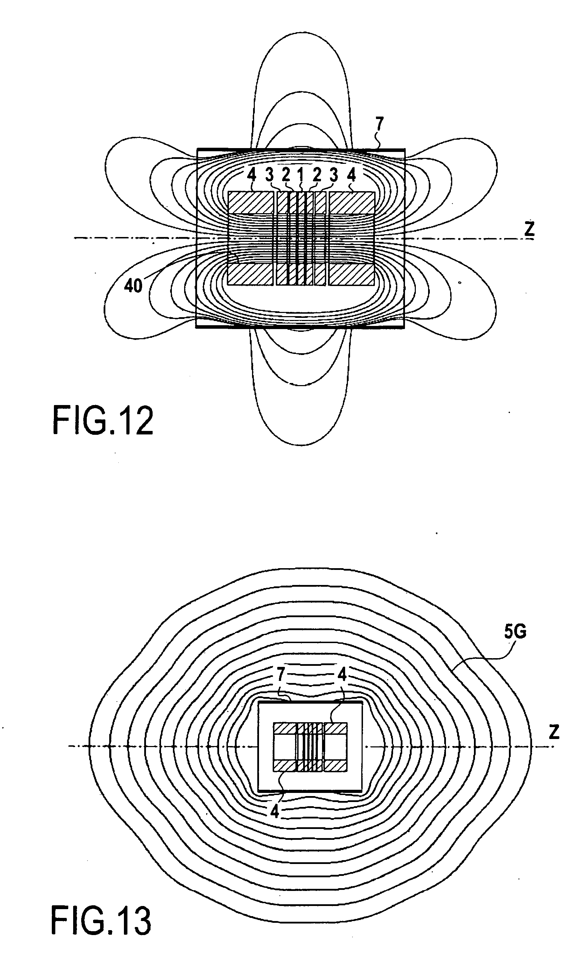

Dans le mode de réalisation des Figures 12 et 13, il existe un seul bobinage de compensation en couches.

D'une manière générale, il est inutile de multiplier les bobinages de compensation 5, 6 ou 7, qui sont parcourus par des courants de sens inverse à ceux parcourant les bobinages des blocs 1 à 4. Il est de même inutile et coûteux d'imposer que chacun des bobinages produise un champ intérieur homogène, puisqu'il suffit que le champ total le soit.

On a déjà rappelé plus haut les conditions pour l'obtention d'un champ le plus homogène possible dans le volume d'intérêt autour d'une origine O.

On peut raisonner de manière similaire pour caractériser le champ extérieur, mais en se plaçant cette fois à l'extérieur d'une sphère de centre O, centre de l'aimant, et de rayon $r_{min}$ qui englobe complètement les sources de champ magnétique. Les bobinages de l'aimant sont donc situés entre cette sphère et la sphère de rayon $r_{max}$ définie plus haut.

A l'extérieur de cette sphère, chaque composante $B_x$, $B_y$ et $B_z$ du champ magnétique a son laplacien nul et un développement unique en harmoniques sphériques. Par exemple :

$$B_z(r,\theta,\varphi) = \sum_{n=2}^{\infty} \frac{1}{r^{n+1}} \left[ Z'_n P_n(\cos\theta) + \sum_{m=1}^{n} \left( X'^m_n \cos m\varphi + Y'^m_n \sin m\varphi \right) W^m_n P^m_n(\cos\theta) \right]$$

où la sommation commence à $n = 2$ car il n'existe pas de monopôle magnétique (« correspondant » magnétique de la charge électrique).

Comme pour le développement intérieur, l'ensemble de coefficients $Z'_n, X'^m_n, Y'^m_n$ est unique et permet d'exprimer non seulement $B_z$ mais aussi les autres composantes du champ ainsi que les potentiels scalaire et vecteur dont il dérive. De même, les fonctions $\frac{1}{r^{n+1}} P^m_n(\cos\vartheta)$ $\forall n \geq 0, 0 \leq m \leq n$ constituent un ensemble complet de fonctions orthogonales ce qui implique que l'on obtiendra une décroissance du champ extérieur avec la distance au centre de l'aimant d'autant meilleure que l'on réalisera une géométrie des sources de champ (bobinages) telle que tous ces coefficients soient nuls pour tous les degrés inférieurs ou égaux à un degré donné $n'_0$.

Pour un système de sources possédant, comme dans la situation considérée, une symétrie axiale ou de révolution autour de l'axe *Oz* et un plan de symétrie *xOy,* le développement se réduit à :

$$B_z(r,\theta,\varphi) = \sum_{p=1}^{\infty} Z'_{2p} \frac{1}{r^{2p+1}} P_{2p}(\cos\theta)$$

avec par ailleurs une composante perpendiculaire à l'axe :

$$B_\rho(r,\theta,\varphi) = \sum_{p=1}^{\infty} \frac{1}{2p} Z'_{2p} \frac{1}{r^{2p+1}} P^1_{2p}(\cos\theta)$$

Les coefficients $Z'_{2p}$ sont aussi appelés les « moments » de la distribution de courant, $Z'_2$ est le moment dipolaire, $Z_4$ est le moment quadrupolaire.

Pour concevoir un aimant à blindage actif optimal, il suffira donc de prévoir des bobinages supplémentaires de compensation toujours caractérisés par cinq paramètres $\left(a_1', a_2' > a_1', b_1', b_2' > b_1', j_0'\right)_{i' \in [1, N']}$, de rayons plus grands que ceux du bobinage principal avec des $j_{0i'}'$ de signe contraire à celui des $j_{0i}$ de ce dernier et de déterminer les 5 $(N + N')$ paramètres des bobinages de telle façon que les coefficients des développements du champ total produit soient tels que $Z_{2p} \equiv 0 \ \forall p \leq p_0$ pour réaliser l'homogénéité spatiale intérieure et $Z_{2p}' \equiv 0 \ \ \forall p \leq p_0'$ pour réaliser la décroissance rapide du champ extérieur désirées.

Les conclusions du processus d'optimisation sont alors les suivantes :

- il faut toujours pour l'aimant principal au moins $p_0 + 1$ blocs dont les épaisseurs et les séparations augmentent du centre vers les extrémités. Leurs paramètres sont évidemment ajustés pour tenir compte de la présence d'un aimant de compensation ;

- il suffit d'annuler les deux premiers moments $\left(Z_2' \equiv Z_4' \equiv 0\right)$ et éventuellement le troisième $\left(Z_6' \equiv 0\right)$ pour ramener la limite des 5 gauss à une distance acceptable du centre de l'aimant. Pour ce faire il suffit d'un, deux ou trois bobinages de compensation 5, 6 seulement. On peut même trouver des configurations où un seul bobinage de compensation 7 suffit pour obtenir $Z_2' \equiv Z_4' \equiv 0$ comme dans le mode de réalisation des Figures 12 et 13 ;

- la capacité de transport de courant (volume de supraconducteur) est d'autant plus faible que le rayon extérieur $a_2'$ des bobinages de compensation est plus grand, leur épaisseur $a_2' - a_1'$ diminue. Il faudra donc fixer, dans le processus d'optimisation, une borne supérieure à ce rayon. Par ailleurs la faible épaisseur fait privilégier une réalisation en couches plutôt qu'en doubles galettes pour ces bobinages de compensation. Comme ces bobinages de compensation se trouvent dans une zone de champ relativement faible, on aura intérêt à utiliser un conducteur différent de celui de l'aimant principal afin d'augmenter la densité de courant « hors tout » en valeur absolue ;

- la présence des bobinages de compensation réduit non seulement le champ extérieur mais aussi la différence entre le champ maximum (« peak field ») dans les bobinages principaux et le champ nominal au centre. On peut également introduire ce dernier paramètre dans le processus d'optimisation afin de rendre cette différence aussi petite que possible pour utiliser au mieux les performances du supraconducteur utilisé, plus particulièrement lorsqu'il est près de son champ critique.

Les deux modes de réalisation des Figures 10, 11 et 12, 13 qui comprennent d'une part sept blocs 1 à 4 d'un aimant principal et d'autre part soit deux blocs 5, 6, soit un bloc 7 de bobinages de compensation, alimentés par des courants en sens inverse de celui des courants parcourant les blocs 1 à 4, peuvent être adaptés par exemple à une installation comportant un tunnel intérieur 40 de diamètre D = 1 m.

Dans un exemple particulier de réalisation, on a les valeurs suivantes pour les divers paramètres $B_0$ (induction du champ magnétique de base), D (diamètre du tunnel intérieur), $J_0$ (densité de courant), $V_{bob}$ (volume des bobinages) et W (énergie magnétique stockée dans l'aimant) :

$B_0$ = 11,7436T (500 MHz)
D = 1 m
$|j_0|$ = 34,612 A/mm² (aimant principal et compensations)
$V_{bob.}$ = 8,204 m³
W = 300 MJ.

Dans cet exemple particulier,

- l'aimant principal est constitué de 203 doubles galettes ;

- afin d'utiliser comme supraconducteur du NbTi, l'aimant, est plongé dans un bain d'hélium superfluide à pression normale suivant le brevet US 3 992 893.

L'homogénéité théorique ($p_0 = 6$) est gouvernée par $Z_{14}$, soit mieux que 0,006 ppm dans une sphère de diamètre 200 *mm* et mieux que 0,006 ppm dans une sphère de diamètre 500 *mm.* Le champ extérieur $(p_0' = 2)$ est gouverné par $Z_6'$, c'est-à-dire que l'aimant est, pour l'extérieur, un hexapôle comme le montrent les lignes de champ des Figures 10 et 12.

Les Figures 11 et 13 montrent la limite des 5 gauss (0,5 mT), chacune des autres lignes correspondant à une valeur de champ multipliée par deux par rapport à la précédente en se rapprochant du centre ou divisée par deux s'éloignant. La ligne la plus extérieure correspond donc à 1,25 gauss (0,125 mT) et la plus interne à 2560 gauss (0.256 *T*).

Enfin, le champ maximum sur le conducteur ne dépasse que de 0,418% le champ au centre de l'aimant, ce qui est tout à fait remarquable.

**Revendications**

1. Dispositif de création d'un champ magnétique homogène dans une zone d'intérêt, pour la résonance magnétique nucléaire et l'imagerie par résonance magnétique, comprenant un agencement de bobines supraconductrices disposées autour d'un axe longitudinal (z) de ladite zone d'intérêt, laquelle zone d'intérêt se trouve à l'intérieur dudit agencement de bobines supraconductrices,
l'agencement de bobines supraconductrices comprenant un ensemble de un ou plusieurs blocs (1 à 4), chaque bloc (1 à 4) étant formé d'un ensemble d'éléments modulaires (8) répartis le long dudit axe longitudinal (z) et centrés sur cet axe longitudinal (z), chaque élément modulaire (8) comprenant un conducteur de section rectangulaire en matériau supraconducteur enroulé de façon continue sous la forme d'une double galette avec une première galette simple plane (10), une deuxième galette simple plane (20) juxtaposée à la première galette simple (10) parallèlement à celle-ci et un tronçon de transition (30) sans jonction interne entre les première et deuxième galettes simples (10, 20), chaque galette simple (10, 20) comprenant une extrémité de raccordement (11, 21) située à la partie périphérique externe de la galette pour un raccordement par une jonction à une extrémité de raccordement d'un élément modulaire voisin et le tronçon de transition (30) permettant, suivant l'axe longitudinal (z), un décalage de la deuxième galette simple (20) par rapport à la première galette simple (10), au moins égal à la dimension transversale du conducteur selon cet axe, **caractérisé en ce que** chacune des première et deuxième galettes simples planes (10, 20) est réalisée à partir de demi-circonférences de rayon croissant de la moitié de l'épaisseur du conducteur entre deux demi-circonférences consécutives, avec une alternance entre deux centres pour les demi-circonférences, séparés de la moitié de l'épaisseur du conducteur.

2. Dispositif selon la revendication 1, **caractérisé en ce que** des premières cales isolantes (51) sont disposées entre la première galette simple (10) et la deuxième galette simple (20) au sein de chaque élément modulaire (8) et des deuxièmes cales isolantes (61) sont disposées entre les éléments modulaires (8) successifs.

3. Dispositif selon la revendication 1 ou la revendication 2, **caractérisé en ce que** le tronçon de transition (30) s'étend autour de l'axe longitudinal (z) sur un intervalle inférieur à $2\pi$.

4. Dispositif selon la revendication 3, **caractérisé en ce que** le tronçon de transition (30) s'étend autour de l'axe longitudinal (z) sur un intervalle inférieur à $\pi$.

5. Dispositif selon l'une quelconque des revendications 1 à 4, **caractérisé en ce que** le tronçon de transition (300) est réalisé sous la forme d'une couronne sinusoïdale constituée par l'enroulement d'une sinusoïde autour d'un cylindre de révolution ayant pour axe ledit axe longitudinal (z).

6. Dispositif selon l'une quelconque des revendications 1 à 5, **caractérisé en ce que** chaque bloc (1 à 4) comprend plusieurs dizaines d'éléments modulaires identiques (8).

7. Dispositif selon l'une quelconque des revendications 1 à 6, **caractérisé en ce qu'**il comprend au moins sept blocs (1 à 4) d'éléments modulaires identiques (8), disposés coaxialement selon ledit axe longitudinal (z) symétriquement par rapport à un plan médian de la zone d'intérêt perpendiculaire audit axe longitudinal (z), l'épaisseur des blocs (1 à 4) et la longueur de l'espace libre de séparation entre deux blocs adjacents augmentant du plan médian vers les extrémités du dispositif.

8. Dispositif selon l'une quelconque des revendications 1 à 7, **caractérisé en ce qu'**il comprend en outre au moins une bobine supraconductrice de compensation (5, 6 ; 7) qui entoure les blocs (1 à 4) d'éléments modulaires (8) et présente un axe coïncidant avec l'axe longitudinal (z), ladite bobine supraconductrice de compensation (5, 6 ; 7) étant adaptée pour être parcourue par un courant de sens inverse à ceux desdits blocs (1 à 4).

9. Dispositif selon la revendication 8, **caractérisé en ce que** l'ensemble des blocs (1 à 4) et bobines de compensation (5, 6 ; 7) parcourus par des courants sont configurés de telle manière qu'au moins le moment dipolaire $Z'_2$ de la distribution de courant correspondant au champ magnétique à l'extérieur de la zone d'intérêt est nul, en même temps que les coefficients $Z_{2p}$ du développement du champ magnétique dans la zone d'intérêt sont nuls jusqu'à un ordre supérieur à 2 fixé $Z_{2p0}$.

10. Dispositif selon la revendication 8, **caractérisé en ce que** l'ensemble des blocs (1 à 4) et bobines de compensation (5, 6 ; 7) parcourus par des courants sont configurés de telle manière qu'au moins le moment dipolaire $Z'_2$ et le moment quadrupolaire $Z'_4$ de la distribution de courant correspondant au champ magnétique à l'extérieur de la zone d'intérêt sont nuls, en même temps que les coefficients $Z_{2p}$ du développement du champ magnétique dans la zone d'intérêt sont nuls jusqu'à un ordre supérieur à 2 fixé $Z_{2p0}$.

11. Dispositif selon la revendication 8, **caractérisé en ce que** l'ensemble des blocs (1 à 4) et bobines de compensation (5, 6 ; 7) parcourus par des courants sont configurés de telle manière que les moments magnétiques multipolaires de la distribution de courant correspondant au champ magnétique à l'extérieur de la zone d'intérêt sont nuls depuis l'ordre inférieur 2 ($Z'_2$) jusqu'à un ordre supérieur à 2 fixé $Z'_{2p0}$ en même temps que les coefficients $Z_{2p}$ du développement du champ magnétique dans la zone d'intérêt sont nuls jusqu'à un ordre supérieur à 2 fixé $Z_{2p0}$.

12. Dispositif selon l'une quelconque des revendications 8 à 11, **caractérisé en ce que** la bobine supraconductrice de compensation (5, 6 ; 7) est réalisée sous la forme d'un bobinage en couches.

13. Dispositif selon l'une quelconque des revendications 1 à 12, **caractérisé en ce que** les blocs (1 à 4) d'éléments modulaires sont disposés autour d'une zone d'intérêt dont le diamètre est égal ou supérieur à 1 mètre.

14. Dispositif selon l'une quelconque des revendications 1 à 13, **caractérisé en ce que** les blocs (1 à 4) d'éléments modulaires sont configurés de telle manière que le champ magnétique créé par ces blocs (1 à 4) est supérieur ou égal à 10 T.

15. Dispositif selon l'une quelconque des revendications 1 à 14, **caractérisé en ce que** la section du conducteur d'un élément modulaire (8) est comprise entre quelques millimètres carrés et quelques dizaines de millimètres carrés.

16. Dispositif selon l'une quelconque des revendications 1 à 14, **caractérisé en ce qu'**un élément modulaire (8) présente une masse comprise entre quelques dizaines de kilogrammes et une centaine de kilogrammes.

17. Procédé de fabrication d'un dispositif de création d'un champ magnétique homogène dans une zone d'intérêt pour la résonance magnétique nucléaire et l'imagerie par résonance magnétique, **caractérisé en ce qu'**il comprend les étapes suivantes :

a) préparer une longueur de fil de matériau supraconducteur à section rectangulaire sans raccord,
b) mettre en forme un tronçon central de la longueur de fil pour créer un tronçon de transition (30) entre deux galettes simples juxtaposées,
c) disposer sur un mandrin de forme spécifique et rendre provisoirement solidaire de celui-ci le tronçon de transition (30) formé et la moitié de la longueur de fil s'étendant d'un côté du tronçon de transition (30),
d) former par rotation du mandrin dans un premier sens une première galette simple plane (10) à partir de l'autre moitié de la longueur de fil restée libre par rapport au mandrin, le mandrin présentant une forme telle que la première galette simple plane (10) est formée de demi-circonférences de rayon croissant de la moitié de l'épaisseur du conducteur entre deux demi-circonférences consécutives, avec une alternance entre deux centres pour les demi-circonférences, séparés de la moitié de l'épaisseur du conducteur,
e) rendre provisoirement solidaire du mandrin la première galette simple formée (10) et libérer le tronçon de transition (30) de la moitié de la longueur de fil précédemment rendue provisoirement solidaire du mandrin,
f) former par rotation du mandrin dans un deuxième sens une deuxième galette simple plane (20) à partir de la moitié de la longueur du fil libérée, le mandrin présentant une forme telle que la deuxième galette simple plane (20) est formée de demi-circonférences de rayon croissant de la moitié de l'épaisseur du conducteur entre deux demi-circonférences consécutives, avec une alternance entre deux centres pour les demi-circonférences, séparés de la moitié de l'épaisseur du conducteur,

g) retirer du mandrin l'élément modulaire (8) obtenu et former des extrémités de raccordement (11, 21) à la partie périphérique externe de chaque galette simple (10, 20), et

h) assembler et raccorder le long d'un axe longitudinal (z) une pluralité d'éléments modulaires (8) préparés selon les étapes a) à g).

**18.** Procédé selon la revendication 17, **caractérisé en ce qu'**il comprend en outre l'étape d'insérer de premières cales isolantes (51) entre la première galette simple (10) et la deuxième galette simple (20) au sein de chaque élément modulaire (8) et d'insérer de deuxièmes cales isolantes (61) entre les différents éléments modulaires (8) successifs d'un même bloc.


**Claims**

**1.** A device for creating a uniform magnetic field in a zone of interest, for nuclear magnetic resonance and magnetic resonance imaging, the device comprising an arrangement of superconductor coils placed around a longitudinal axis (z) of said zone of interest, which zone of interest lies inside said arrangement of superconductor coils, the arrangement of superconductor coils comprising a set of one or several blocks (1 to 4), each block (1 to 4) being formed of a set of modular elements (8) distributed along said longitudinal axis (z) and centered on said longitudinal axis (z), each modular element (8) comprising a conductor of rectangular section made of superconductor material wound continuously in the form of a double pancake coil comprising a first single plane pancake coil (10), a second single plane pancake coil (20) juxtaposed parallel to the first single pancake coil (10), and a transition segment (30) without any internal junction between the first and second single pancake coils (10, 20), each single pancake coil (10, 20) having a connection end (11, 21) situated at the outer peripheral portion of the pancake coil for connection via a junction to a connection end of an adjacent modular element, and the transition segment (30) making it possible to offset the second single pancake coil (20) along the longitudinal axis (z) relative to the first single pancake coil (10) through a distance not less than the transverse dimension of the conductor along said axis, the device being **characterized in that** each of the first and second single plane pancake coils (10, 20) is made from half-circumferences of radius increasing by half the thickness of the conductor between two consecutive half-circumferences, and alternating between two centers for the half-circumferences that are separated by half the thickness of the conductor.

**2.** A device according to claim 1, **characterized in that** first insulating spacers (51) are disposed between the first single pancake coil (10) and the second single pancake coil (20) within each modular element (8), and second insulating spacers (61) are disposed between successive modular elements (8).

**3.** A device according to claim 1 or claim 2, **characterized in that** the transition segment (30) extends around the longitudinal axis (z) over an extent of less than $2\pi$.

**4.** A device according to claim 3, **characterized in that** the transition segment (30) extends around the longitudinal axis (z) over an extent that is less than $\pi$.

**5.** A device according to any one of claims 1 to 4, **characterized in that** the transition segment (300) is made in the form of a sinusoidal ring constituted by winding a sinewave around a circular cylinder having said longitudinal axis (z) as its axis.

**6.** A device according to any one of claims 1 to 5, **characterized in that** each block (1 to 4) comprises several tens of identical modular elements (8).

**7.** A device according to any one of claims 1 to 6, **characterized in that** it comprises at least seven blocks (1 to 4) of identical modular elements (8) disposed in alignment along said longitudinal axis (z) and symmetrically about a midplane of the zone of interest that is perpendicular to said longitudinal axis (z), the thicknesses of the blocks (1 to 4) and the lengths of the empty separation spaces between pairs of adjacent blocks increasing going away from the midplane towards the ends of the device.

**8.** A device according to any one of claims 1 to 7, **characterized in that** it further comprises at least one superconductive compensation coil (5, 6; 7) surrounding the blocks (1 to 4) of modular elements (8) and presenting an axis that coincides with the longitudinal axis (z), said superconductive compensation coil (5, 6; 7) being adapted to convey a current in the direction that is opposite to the direction of the current in said blocks (1 to 4) .

9. A device according to claim 8, **characterized in that** the set of blocks (1 to 4) and of compensation coils (5, 6; 7) conveying currents is configured in such a manner that at least the dipolar moment $Z'_2$ of the current distribution corresponding to the magnetic field outside the zone of interest is zero, while simultaneously the coefficients $Z_{2p}$ of the development of the magnetic field in the zone of interest are zero up to a fixed order $Z_{2p0}$ greater than 2.

10. A device according to claim 8, **characterized in that** the set of blocks (1 to 4) and of compensation coils (5, 6; 7) conveying currents is configured in such a manner that at least the dipolar moment $Z'_2$ and the quadrupolar moment $Z'_4$ of the current distribution corresponding to the magnetic field outside the zone of interest are zero, while simultaneously the coefficients $Z_{2p}$ of the development of the magnetic field in the zone of interest are zero up to a fixed order $Z_{2p0}$ greater than 2.

11. A device according to claim 8, **characterized in that** the set of blocks (1 to 4) and of compensation coils (5, 6; 7) conveying currents is configured in such a manner that the multipolar magnetic moments of the current distribution corresponding to the magnetic field outside the zone of interest are zero from the minimum order 2 ($Z'_2$) up to a fixed order $Z'_{2p0}$ greater than 2, while simultaneously the coefficients $Z_{2p}$ of the development of the magnetic field in the zone of interest are zero up to a fixed order $Z_{2p0}$ greater than 2.

12. A device according to any one of claims 8 to 11, **characterized in that** the superconductive compensation coil (5, 6; 7) is made in the form of a layer coil.

13. A device according to any one of claims 1 to 12, **characterized in that** the blocks (1 to 4) of modular elements are placed around a zone of interest of diameter equal to or greater than 1 meter.

14. A device according to any one of claims 1 to 13, **characterized in that** the blocks (1 to 4) of modular elements are configured in such a manner that the magnetic field created by these blocks (1 to 4) is greater than or equal to 10 T.

15. A device according to any one of claims 1 to 14, **characterized in that** the section of the conductor of a modular element (8) lies in the range a few square millimeters to several tens of square millimeters.

16. A device according to any one of claims 1 to 14, **characterized in that** a modular element (8) presents weight lying in the range a few tens of kilograms to about one hundred kilograms.

17. A method of fabricating a device for creating a uniform magnetic field in a zone of interest, for nuclear magnetic resonance and magnetic resonance imaging, the method being **characterized in that** it comprises the following steps:

a) preparing a length of superconductor material wire of rectangular section and without connection;
b) putting the length of wire into the form of a central segment for creating a transition segment (30) between two juxtaposed single pancake coils;
c) placing the resulting transition segment (30) and half of the length of wire extending from the transition segment (30) into place on a mandrel of special shape, and temporarily securing them thereto;
d) turning the mandrel in a first direction to form a first single plane pancake coil (10) from the other half of the length of wire that is left free relative to the mandrel, the mandrel being of a shape such that the first single plane pancake coil (10) is made up of half-circumferences of radii that increase by half the thickness of the conductor between two consecutive half-circumferences, with the half-circumferences alternating between two centers that are spaced apart by half the thickness of the conductor;
e) temporarily securing the mandrel to the first single pancake coil (10) that has been formed and releasing the transition segment (30) from the half of the length of wire that was previously temporarily secured to the mandrel;
f) causing the mandrel to turn in a second direction to form a second single plane pancake coil (20) from the release half of the length of the wire, the mandrel presenting a shape such that the second single plane pancake coil (20) is made up of half-circumferences of radii that increase by half the thickness of the conductor between two consecutive half-circumferences, with the half-circumferences alternating between two centers that are spaced apart by half the thickness of the conductor;
g) removing from the mandrel the resulting modular element (8) and forming connection ends (11, 21) at the outer peripheral portion of each single pancake coil (10, 20); and
h) assembling and connecting together along a longitudinal axis (z) a plurality of modular elements (8) prepared in accordance with steps a) to g).

**18.** A method according to claim 17, **characterized in that** it further includes the step of inserting first insulating spacers (51) between the first single pancake coil (10) and the second single pancake coil (20) within each modular element (8), and of inserting second insulating spacers (61) between the various successive modular elements (8) making up a same block.

## Patentansprüche

**1.** Vorrichtung zur Erzeugung eines homogenen Magnetfeldes in einem interessierenden Bereich, für die Kernspinresonanz und die Kernspintomographie, umfassend eine Anordnung von supraleitenden Spulen, die um eine Längsachse (z) des interessierenden Bereichs herum angeordnet sind, wobei der interessierende Bereich innerhalb der Anordnung von supraleitenden Spulen gelegen ist,
wobei die Anordnung von supraleitenden Spulen eine Einheit aus einem oder mehreren Blöcken (1 bis 4) umfaßt, wobei jeder Block (1 bis 4) von einer Einheit aus modularen Elementen (8), die entlang der Längsachse (z) verteilt und um diese Längsachse (z) zentriert sind, gebildet ist, wobei jedes modulare Element (8) einen Leiter mit rechteckigem Querschnitt aus supraleitendem Material umfaßt, der in Form einer Doppelflachspule, mit einer ersten ebenen Einfachflachspule (10), einer zweiten ebenen Einfachflachspule (20), die neben der ersten Einfachflachspule (10) parallel zu dieser angeordnet ist, und einem Übergangsabschnitt (30) ohne Innenverbindung zwischen der ersten und der zweiten Einfachflachspule (10, 20) fortlaufend gewickelt ist, wobei jede Einfachflachspule (10, 20) ein Anschlußende (11, 21), das am Außenumfangsteil der Flachspule gelegen ist, für ein Anschließen über eine Verbindung an ein Anschlußende eines benachbarten modularen Elements umfaßt und wobei der Übergangsabschnitt (30) entlang der Längsachse (z) einen Versatz der zweiten Einfachflachspule (20) gegenüber der ersten Einfachflachspule (10) ermöglicht, der wenigstens gleich der Querabmessung des Leiters entlang dieser Achse ist, **dadurch gekennzeichnet, daß** eine jede der ersten und der zweiten ebenen Einfachflachspule (10, 20) aus halben Umfängen mit einem Radius, der zwischen zwei aufeinanderfolgenden halben Umfängen um die Hälfte der Dicke des Leiters zunimmt, gebildet ist, mit einem Wechsel zwischen zwei um die Hälfte der Dicke des Leiters getrennten Mittelpunkten für die halben Umfänge.

**2.** Vorrichtung nach Anspruch 1, **dadurch gekennzeichnet, daß** erste isolierende Keile (51) zwischen der ersten Einfachflachspule (10) und der zweiten Einfachflachspule (20) innerhalb eines jeden modularen Elements (8) angeordnet sind und zweite isolierende Keile (61) zwischen den aufeinanderfolgenden modularen Elementen (8) angeordnet sind.

**3.** Vorrichtung nach Anspruch 1 oder Anspruch 2, **dadurch gekennzeichnet, daß** der Übergangsabschnitt (30) sich um die Längsachse (z) über ein Intervall kleiner als $2\pi$ erstreckt.

**4.** Vorrichtung nach Anspruch 3, **dadurch gekennzeichnet, daß** der Übergangsabschnitt (30) sich um die Längsachse (z) über ein Intervall kleiner als $\pi$ erstreckt.

**5.** Vorrichtung nach einem der Ansprüche 1 bis 4, **dadurch gekennzeichnet, daß** der Übergangsabschnitt (300) in Form einer Sinuskrone ausgebildet ist, die durch Wickeln einer Sinuslinie um einen Rotationszylinder, der als Achse die Längsachse (z) hat, gebildet ist.

**6.** Vorrichtung nach einem der Ansprüche 1 bis 5, **dadurch gekennzeichnet, daß** jeder Block (1 bis 4) mehrere zehn identische modulare Elemente (8) umfaßt.

**7.** Vorrichtung nach einem der Ansprüche 1 bis 6, **dadurch gekennzeichnet, daß** sie wenigstens sieben Blöcke (1 bis 4) von identischen modularen Elementen (8) umfaßt, die entlang der Längsachse (z) koaxial, zu einer zu der Längsachse (z) senkrechten Mittelebene des interessierenden Bereichs symmetrisch angeordnet sind, wobei die Dicke der Blöcke (1 bis 4) und die Länge des Freiraums zur Trennung zwischen zwei benachbarten Blöcken von der Mittelebene zu den Enden der Vorrichtung zunehmen.

**8.** Vorrichtung nach einem der Ansprüche 1 bis 7, **dadurch gekennzeichnet, daß** sie ferner wenigstens eine supraleitende Kompensationsspule (5, 6; 7) umfaßt, die die Blöcke (1 bis 4) von modularen Elementen (8) umgibt und eine mit der Längsachse (z) zusammenfallende Achse aufweist, wobei die supraleitende Kompensationsspule (5, 6; 7) dazu ausgelegt ist, von einem Strom mit einer zu denjenigen der Blöcke (1 bis 4) entgegengesetzten Richtung durchflossen zu werden.

9. Vorrichtung nach Anspruch 8, **dadurch gekennzeichnet, daß** alle Blöcke (1 bis 4) und von Strömen durchflossene Kompensationsspulen (5, 6; 7) derart gestaltet sind, daß wenigstens das Dipolmoment $Z'_2$ der Stromverteilung, die dem Magnetfeld außerhalb des interessierenden Bereichs entspricht, null ist, gleichzeitig die Koeffizienten $Z_{2p}$ der Entwicklung des Magnetfeldes in dem interessierenden Bereich bis zu einer festgelegten Ordnung größer 2 $Z_{2p0}$ null sind.

10. Vorrichtung nach Anspruch 8, **dadurch gekennzeichnet, daß** alle Blöcke (1 bis 4) und von Strömen durchflossene Kompensationsspulen (5, 6; 7) derart gestaltet sind, daß wenigstens das Dipolmoment $Z'_2$ und das Quadrupolmoment $Z'_4$ der Stromverteilung, die dem Magnetfeld außerhalb des interessierenden Bereichs entspricht, null sind, gleichzeitig die Koeffizienten $Z_{2p}$ der Entwicklung des Magnetfeldes in dem interessierenden Bereich bis zu einer festgelegten Ordnung größer 2 $Z_{2p0}$ null sind.

11. Vorrichtung nach Anspruch 8, **dadurch gekennzeichnet, daß** alle Blöcke (1 bis 4) und von Strömen durchflossene Kompensationsspulen (5, 6; 7) derart gestaltet sind, daß die magnetischen Multipolmomente der Stromverteilung, die dem Magnetfeld außerhalb des interessierenden Bereichs entspricht, von der Ordnung kleiner 2 ($Z'_2$) bis zu einer festgelegten Ordnung größer 2 $Z'_{2p0}$ null sind, gleichzeitig die Koeffizienten $Z_{2p}$ der Entwicklung des Magnetfeldes in dem interessierenden Bereich bis zu einer festgelegten Ordnung größer 2 $Z_{2p0}$ null sind.

12. Vorrichtung nach einem der Ansprüche 8 bis 11, **dadurch gekennzeichnet, daß** die supraleitende Kompensationsspule (5, 6; 7) in Form einer Schichtwicklung ausgebildet ist.

13. Vorrichtung nach einem der Ansprüche 1 bis 12, **dadurch gekennzeichnet, daß** die Blöcke (1 bis 4) von modularen Elementen um einen interessierenden Bereich herum angeordnet sind, dessen Durchmesser gleich oder größer als 1 Meter ist.

14. Vorrichtung nach einem der Ansprüche 1 bis 13, **dadurch gekennzeichnet, daß** die Blöcke (1 bis 4) von modularen Elementen derart gestaltet sind, daß das durch diese Blöcke (1 bis 4) erzeugte Magnetfeld größer oder gleich 10 T ist.

15. Vorrichtung nach einem der Ansprüche 1 bis 14, **dadurch gekennzeichnet, daß** der Querschnitt des Leiters eines modularen Elements (8) im Bereich zwischen einigen Quadratmillimetern und einigen zehn Quadratmillimetern liegt.

16. Vorrichtung nach einem der Ansprüche 1 bis 14, **dadurch gekennzeichnet, daß** ein modulares Element (8) eine Masse im Bereich zwischen einigen zehn Kilogramm und etwa hundert Kilogramm aufweist.

17. Verfahren zur Herstellung einer Vorrichtung zur Erzeugung eines homogenen Magnetfeldes in einem interessierenden Bereich, für die Kernspinresonanz und die Kernspintomographie, **dadurch gekennzeichnet, daß** es die folgenden Schritte umfaßt:

   a) Vorbereiten einer Länge von Draht aus einem supraleitenden Material mit rechteckigem Querschnitt ohne Anschluß,
   b) Formen eines mittleren Abschnitts der Drahtlänge, um einen Übergangsabschnitt (30) zwischen zwei nebeneinander liegenden Einfachflachspulen zu erzeugen,
   c) Anordnen des geformten Übergangsabschnitts (30) und der Hälfte der Drahtlänge, die sich auf einer Seite des Übergangsabschnitts (30) erstreckt, auf einer Wickelhülse mit spezifischer Form und provisorisches festes Verbinden dieser mit der Wickelhülse,
   d) Bilden einer ersten ebenen Einfachflachspule (10) aus der gegenüber der Wickelhülse frei gebliebenen anderen Hälfte der Drahtlänge, durch Drehen der Wickelhülse in eine erste Richtung, wobei die Wickelhülse eine Form aufweist, die derart ist, daß die erste ebene Einfachflachspule (10) aus halben Umfängen mit einem Radius, der zwischen zwei aufeinanderfolgenden halben Umfängen um die Hälfte der Dicke des Leiters zunimmt, gebildet ist, mit einem Wechsel zwischen zwei um die Hälfte der Dicke des Leiters getrennten Mittelpunkten für die halben Umfänge,
   e) provisorisches festes Verbinden der gebildeten ersten Einfachflachspule (10) mit der Wickelhülse und Lösen des Übergangsabschnitts (30) von der Hälfte der Drahtlänge, die zuvor mit der Wickelhülse provisorisch fest verbunden wurde,
   f) Bilden einer zweiten ebenen Einfachflachspule (20) aus der gelösten Hälfte der Länge des Drahtes, durch Drehen der Wickelhülse in eine zweite Richtung, wobei die Wickelhülse eine Form aufweist, die derart ist, daß die zweite ebene Einfachflachspule (20) aus halben Umfängen mit einem Radius, der zwischen zwei aufeinanderfolgenden halben Umfängen um die Hälfte der Dicke des Leiters zunimmt, gebildet ist, mit einem Wechsel zwischen zwei um die Hälfte der Dicke des Leiters getrennten Mittelpunkten für die halben Umfänge,

g) Abnehmen des erhaltenen modularen Elements (8) von der Wickelhülse und Bilden der Anschlußenden (11, 21) am Außenumfangsteil einer jeden Einfachflachspule (10, 20) und

h) Zusammenfügen und Verbinden einer Vielzahl von gemäß den Schritten a) bis g) hergestellten modularen Elementen (8) entlang einer Längsachse (z).

18. Verfahren nach Anspruch 17, **dadurch gekennzeichnet, daß** es ferner den Schritt des Einfügens von ersten isolierenden Keilen (51) zwischen der ersten Einfachflachspule (10) und der zweiten Einfachflachspule (20) innerhalb eines jeden modularen Elements (8) und des Einfügens von zweiten isolierenden Keilen (61) zwischen den verschiedenen aufeinanderfolgenden modularen Elementen (8) eines gleichen Blocks umfaßt.

**FIG.1**

**FIG.2**

**FIG.3**

FIG.4

11

12

10

FIG.5

11

12

31

32

30

10

10

20

FIG.6

21

11

22

32

30

40

FIG.7

FIG.8

FIG.9

FIG.10

FIG.11

FIG.12

FIG.13

FIG.14

FIG.14A

FIG.15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0724273 A
- US 5581220 A
- US 4748429 A
- US 3992893 A

**Littérature non-brevet citée dans la description**

- **W. L. L. LENDERS.** *Philips Tech. Rev.,* 1962, vol. 23, 365-404